# EUROPEAN PATENT APPLICATION

(11) **EP 4 700 473 A1**
(43) Date of publication of application: **25.02.2026**
(21) Application number: 24195410.6
(22) Date of filing: 20.08.2024
(51) Int. Cl.: G03F 7/00, F16L 55/02, F24F 13/24

(54) **SILENCER FOR THERMAL CONDITIONING SYSTEM AND METHOD FOR FILLING THEREOF, THERMAL CONDITIONING METHOD, AND LITHOGRAPHIC APPARATUS**

(71) Applicant: ASML Netherlands B.V., 5500 AH Veldhoven (NL)
(72) Inventor: REZAEIHA, Abdolrahim, 5500 AH Veldhoven (NL); FEIJTS, Maurice, Wilhelmus, Leonardus, Hendricus, 5500 AH Veldhoven (NL); BALARAJ, Vignesh, Srinivasan, 5500 AH Veldhoven (NL)
(74) Representative: ASML Netherlands B.V.

(57) **Abstract**

A silencer configured to silence an acoustic wave in a thermal conditioning fluid in a thermal conditioning fluid duct, the silencer comprising:
- a silencer housing comprising an inner cavity, wherein a thermal conditioning fluid cavity is arranged inside the inner cavity,
- a first entrance arranged in the housing wall,
- a first channel connected to the first entrance,
- a second entrance arranged in the housing wall,
- a second channel connected to the second entrance,
wherein the first channel and the second channel are arranged fully outside the housing wall, and a lithographic apparatus comprising the silencer, a method of filling the silencer, a method of draining the silencer, a method of thermally conditioning an object using the silencer.

## Description

### FIELD

The present invention relates to a silencer, a thermal conditioning system comprising such a silencer, a lithographic apparatus comprising such thermal conditioning system, and a method of thermally conditioning an object of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Objects of the lithographic apparatus may be provided with a thermal conditioning system, which comprises a fluid duct for guiding a thermal conditioning fluid. The fluid duct is configured to guide the thermal conditioning fluid to the object that is to be thermally conditioned, through the object and to discharge the thermal conditioning fluid from the object. The object may for example be a projection system mirror of a projection system of the lithographic apparatus or may for example be a stage, such as a wafer table of the lithographic apparatus. It has been observed that the thermal conditioning duct may guide disturbances, such as vibrations, to the object. This may be undesirable, as such disturbances may result in e.g. a vibration or other movement of the object. It has been suggested to provide the thermal conditioning duct with a silencer which may provide a compliance in order to suppress the disturbance. A movement of the object, such as a mirror or a substrate table of the lithographic apparatus may result in an inaccuracy in the imaging of a pattern on the substate. The inaccuracy may translate into an overlay error which may adversely affect an accuracy of the lithographic apparatus.

### SUMMARY

It is desired to provide a lithographic apparatus having a high overlay accuracy.

According to a first aspect of the invention, there is provided a silencer according to claim 1.

According to an embodiment of the first aspect of the invention, there is provided a silencer according to claim 2.

According to an embodiment of the first aspect of the invention, there is provided a silencer according to claim 3.

According to an embodiment of the first aspect of the invention, there is provided a silencer according to claim 4.

According to an embodiment of the first aspect of the invention, there is provided a silencer according to claim 5.

According to an embodiment of the first aspect of the invention, there is provided a silencer according to claim 6.

According to an embodiment of the first aspect of the invention, there is provided a silencer according to claim 7.

According to an embodiment of the first aspect of the invention, there is provided a silencer according to claim 8.

According to an embodiment of the first aspect of the invention, there is provided a silencer according to claim 9.

According to an embodiment of the first aspect of the invention, there is provided a silencer according to claim 10.

According to an embodiment of the first aspect of the invention, there is provided a silencer according to claim 11.

According to an embodiment of the first aspect of the invention, there is provided a silencer according to claim 12.

According to an embodiment of the first aspect of the invention, there is provided a silencer according to claim 13.

According to an embodiment of the first aspect of the invention, there is provided a silencer according to claim 14.

According to an embodiment of the first aspect of the invention, there is provided a silencer according to claim 15.

According to an embodiment of the first aspect of the invention, there is provided a silencer according to claim 16.

According to an embodiment of the first aspect of the invention, there is provided a silencer according to claim 17.

According to an embodiment of the first aspect of the invention, there is provided a silencer according to claim 18.

According to an embodiment of the first aspect of the invention, there is provided a silencer according to claim 19.

According to a second aspect of the invention, there is provided a thermal conditioning system according to claim 20.

According to a third aspect of the invention, there is provided a lithographic apparatus according to claim 21.

According to an embodiment of the third aspect of the invention, there is provided a lithographic apparatus according to claim 22.

According to an embodiment of the third aspect of the invention, there is provided a lithographic apparatus according to claim 23.

According to a fourth aspect of the invention, there is provided a method of thermally conditioning an object according to claim 24.

According to a fifth aspect of the invention, there is provided a method of removing liquid from a silencer according to claim 25.

According to a sixth aspect of the invention, there is provided a method of filling a silencer with a liquid according to claim 26.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a radiation source;
- Figure 2A schematically depicts a cross section of a silencer according to the prior art;
- Figure 2B schematically depicts a cross section of the silencer of figure 2A during a draining operation;
- Figure 2C schematically depicts a cross section of the silencer of figure 2A during a draining operation at a more advanced stage than shown in figure 2B;
- Figure 3A schematically depicts a cross section of a silencer of an embodiment according to the invention;
- Figure 3B schematically shows a graph of suppression performance for the prior art silencer of figure 2A and the silencer of an embodiment according to the invention of figure 3A;
- Figure 3C shows a perspective view of the silencer of figure 3A;
- Figure 4 schematically depicts a cross section of a silencer of an embodiment according to the invention;
- Figure 5 schematically depicts a cross section of a silencer of an embodiment according to the invention.

### DETAILED DESCRIPTION

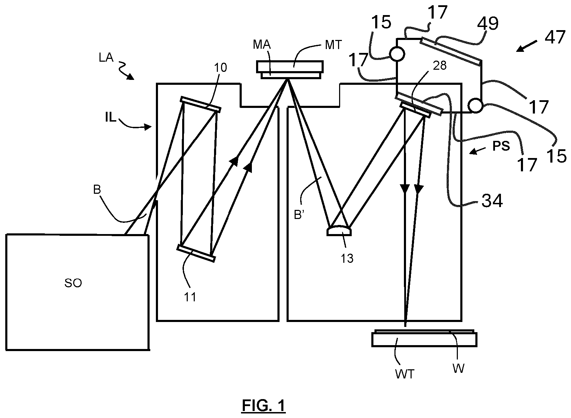

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The lithographic apparatus LA shown in figure 1 comprises a thermal conditioning system 47 to thermally condition one of the mirrors 14. The thermal conditioning system 47 comprises a first heat exchanger 48 configured to exchange heat with the mirror 14 to thermally condition the mirror 14. The first heat exchanger 48 is connected to a second heat exchanger 49 which exchanges heat with a source such as a heating source or a cooling source or an environment, to provide the heat or cooling input necessary for thermally conditioning the mirror 14. Thermal conditioning fluid 16 flows between the heat exchangers 48, 49 via thermal conditioning fluid ducts 17. Two silencers 15 are arranged in the thermal conditioning fluid ducts 17, one on each leg of the circuit of the ducts 17. Said silencers 15 suppress vibrations of the thermal conditioning fluid 16, as such vibrations could negatively impact the mirror 14. It is noted here that suppression is defined differently than damping. Damping entails that energy is dissipated, e.g. by converting vibrational energy into heat or another form of energy. Suppression in the context of this patent application entails that vibrations are suppressed due to destructive interference of an incoming wave and a reflected wave.

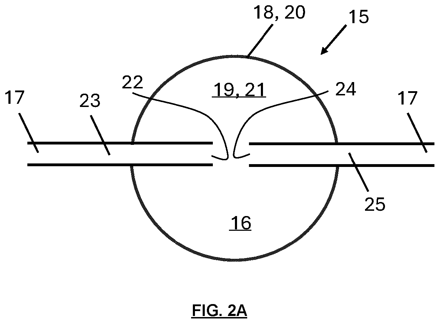

Figure 2A shows a silencer according to the prior art. In operation, a thermal conditioning fluid 16, usually a liquid such as water, flows into the silencer 15 via the first channel 23, flowing into a fluid cavity 21 and subsequently flows out of the silencer 15 via the second channel 25. Vibrations are suppressed in the fluid cavity 21 formed by a housing wall 20 of a housing 18, by destructive interference of an incoming wave and a reflected wave.

During filling of the silencer 15, the silencer 15 can be initially vacuum filled and then filled with liquid thermal conditioning fluid 16 at proper temperature, pressure and flow rate. Alternatively, other filling procedures could be high-pressure filling or filling using CO2, which dissolves 40-50 better than air in water. Nevertheless, it is important that the fluid cavity 21 of the silencer 15 becomes completely gas free in order to guarantee a stable performance and any remaining gas bubbles need to be avoided.

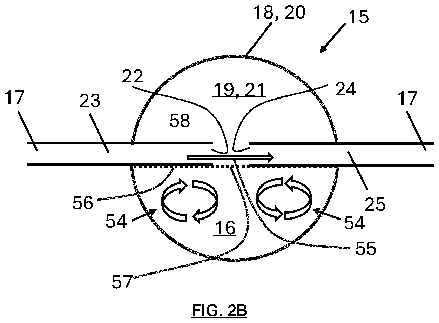

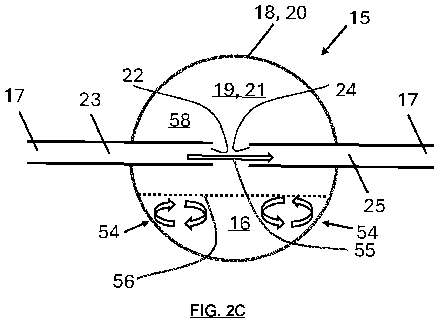

During draining of the silencer 15, the liquid thermal conditioning fluid 16 in the circuit is pushed out using gas 58 such as air at a higher pressure and temperature with a given flow rate. At this stage, it is crucial that the silencer 15 becomes completely dry and free from liquid thermal conditioning fluid 16. Remaining liquid thermal conditioning fluid 16 can cause corrosion and/or leakage in sensitive areas of a device in which the silencer 15 is incorporated, e.g. a lithographic apparatus LA. It has been found that filling and draining of prior art silencers as shown in figure 2 will be an extremely challenging process, requiring much more time than is desired. This is at least partly caused by the fact that the first channel 23 and the second channel 25 protrude into the fluid cavity 21. This may not only cause dead recirculation zones 54 in the fluid chamber during filling and/or draining of the silencer 15, but also limits the interaction between the main flow in the pipe and liquid thermal conditioning fluid 16 in the fluid cavity 21. Figure 2B shows this issue in a schematic way.

Figure 2B shows the silencer 15 of figure 2A in the process of draining. During draining, a gas 58 such as air is supplied to the silencer 15. Thermal conditioning fluid 16 comprising a liquid (e.g. water) present in the silencer 15 is forced out by the gas 58 by displacing the liquid thermal conditioning fluid 16, or is removed from the silencer 15 by evaporation into the gas 58 and subsequently flowing out of the silencer 15 with the gas 58. As the level 56 of the liquid thermal conditioning fluid 16 in the silencer 15 falls to the level 56 shown in figure 2B, a small interaction surface 57 between the gas 58 and the liquid thermal conditioning fluid 16 remains, such that evaporation progresses slowly. If the liquid thermal conditioning fluid 16 level 56 falls further, interaction between the flowing gas 58 and the liquid thermal conditioning fluid 16 is limited as well, seeing that the gas 58 mostly flows from the first channel 23 to the second channel 25 or vice versa along a straight line, as indicated by arrow 55. This situation is shown in figure 2C.

To arrive at the situation shown in figure 2B starting out from a silencer 15 fully filled with liquid or another fluid, one only needs to provide a gas or other fluid with a lower density than the fluid with which the silencer 15 is filled via the first channel 23 and/or the second channel 25. The lighter gas or other fluid will then displace the liquid thermal conditioning fluid 16, forcing it out of the silencer 15 via the first channel 23 and/or the second channel 25. This part of the draining operation can thus be performed fairly quickly.

To progress the draining operation from the situation shown in figure 2B to the situation shown in figure 2C, however, one cannot rely on displacing of the liquid thermal conditioning fluid 16. Even if the silencer 15 were to be arranged in a different orientation, a pocket of liquid thermal conditioning fluid 16 would remain inside the silencer 15, which cannot be removed by displacing the liquid thermal conditioning fluid 16. One thus has to rely on evaporation alone. As discussed above, such evaporation progresses slowly due to the limited interaction surface 57 between the gas and the liquid thermal conditioning fluid 16.

The slow progress of the draining operation stems from the first channel 23 and the second channel 25 protruding into the fluid cavity 21. This is a design feature of the silencer 15 which allows it to suppress specific frequencies, referred to as Helmholtz frequency.

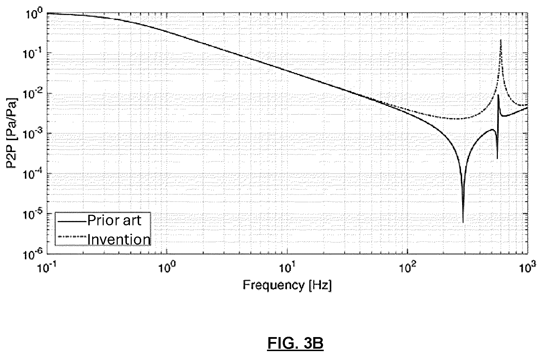

It has been found that the silencer 15 can be modified such that the first channel 23 and the second channel 25 are fully arranged outside housing wall 20 of the silencer 15. It has been found that suppression capabilities are surprisingly preserved to a good enough extent that the silencer 15 is still well usable in a lithographical apparatus. This is shown in the graph shown in fig. 3B.

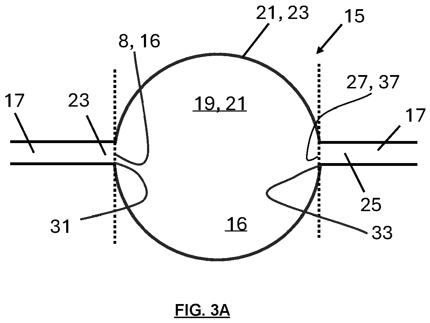

The graph in fig. 3B shows suppression performance of both a prior art silencer 15 as shown in fig. 2A and of a silencer 15 according to the invention as shown in fig. 3A. The suppression performance of the prior art silencer 15 is better between 10² and 10³ Hz, due to the Helmholtz anti-peak suppression which is absent in the silencer 15 according to the invention. However, it has been found that below 10² Hz, suppression performance is mostly similar. It has been found that the regime above 10² Hz is of little interest to some practical applications (e.g. in a lithographic apparatus LA), such that the performance deficit above this frequency does not play a role in practice. Furthermore, the design and dimensions of the silencer 15 may be adapted to change the frequency range where this difference in suppression performance occurs to suit a particular application. It has also been found that the embodiments shown in figures 3A, 4, and 5 respectively have similar suppression performance.

These findings have provided the insight that the design change of the silencer 15 according to the invention as compared to the prior art has no practical detrimental effect, even though it removes the Helmholtz anti-peak suppression effect.

Figures 3A, 3C, 4, and 5 show embodiments of silencers 15 according to the invention. The silencers 15 according to the invention are configured to silence an acoustic wave in a thermal conditioning fluid 16 in a thermal conditioning fluid duct 17. The thermal conditioning fluid duct 17 may be part of a lithographic apparatus LA.

The silencer 15 comprises a silencer housing 18 which has an inner cavity 19 and a housing wall 20 defining the inner cavity 19. A thermal conditioning fluid cavity 21 is arranged inside the inner cavity 19. The housing wall 20 has two openings, each of which forms an entrance to the fluid cavity 21, a first entrance 22 and a second entrance 24. A channel is connected to each of the entrances. A first channel 23 is connected to the first entrance 22 and a second channel 25 is connected to the second entrance 24. The channels are configured to be connected to the thermal conditioning fluid duct 17. The channels and entrances are configured to allow fluid communication between the thermal conditioning fluid duct 17 and thermal conditioning fluid cavity 21. This way, thermal conditioning fluid 16 can be supplied to the thermal conditioning fluid cavity 21 from the thermal conditioning fluid duct 17 and thermal conditioning fluid 16 can be discharged from the thermal conditioning fluid cavity 21 into the thermal conditioning fluid duct 17. In operation, thermal conditioning fluid 16 may flow from the first channel 23 via the first entrance 22 into the thermal conditioning fluid cavity 21 and subsequently out of the thermal conditioning fluid cavity 21 via the second entrance 24 and the second channel 25. Vibrations in the thermal conditioning fluid 16 are suppressed in the thermal conditioning fluid cavity 21.

The first channel 23 and the second channel 25 are arranged fully outside the housing wall 20. They do not protrude into the thermal conditioning fluid cavity 21. Because the first channel 23 and the second channel 25 are arranged fully outside the housing wall 20, pockets of thermal conditioning fluid 16 may not be formed during draining of the silencer 15 of thermal conditioning fluid 16 and/or pockets of gas may not be formed during filling of the silencer 15 with thermal conditioning fluid 16, or at least such pockets may be formed to a lesser extent during filling and/or draining of the silencer 15, as compared to prior art silencers such as the one shown in figures 2A and 2B.

When filling the thermal conditioning fluid cavity 21 with thermal conditioning fluid 16, the thermal conditioning fluid 16 is supplied to the thermal conditioning fluid cavity 21 via the first entrance 22 while simultaneously a different fluid is removed from the thermal conditioning fluid cavity 21 via the second entrance 24. The thermal conditioning fluid 16 may be a liquid. Because the first channel 23 and the second channel 25 are arranged fully outside the housing wall 20, there is a smaller risk of pockets of the different fluid occurring inside the thermal conditioning fluid cavity 21 during filling as compared to prior art silencers. The different fluid may be a gas such as CO₂ or air, which fills the thermal conditioning fluid cavity 21 before it is filled with thermal conditioning fluid 16. Alternatively, the thermal conditioning fluid cavity 21 may be vacuum filled before filling it with the thermal conditioning fluid 16.

When draining the thermal conditioning fluid cavity 21 from thermal conditioning fluid 16, thermal conditioning fluid 16 is drained from the thermal conditioning fluid cavity 21 via the first entrance 22 while simultaneously a different fluid is supplied to the thermal conditioning fluid cavity 21 via the second entrance 24. Similarly to during filling, there is a smaller risk of pockets of the thermal conditioning fluid 16 staying behind in the thermal conditioning fluid cavity 21 during draining as compared to prior art silencers.

The first entrance 22 comprises a first flat entrance plane 30. A first entrance rim 31 surrounds the first entrance 22 and lies in the first flat entrance plane 30. Similarly, the second entrance 24 comprises a second flat entrance plane 32 and a second entrance rim 33 surrounds the second entrance 24 and lies in the second flat entrance plane 32. The thermal conditioning fluid cavity 21 is arranged substantially entirely between the first flat entrance plane 30 and the second flat entrance plane 32. This further tends to reduce the occurrence of pockets of thermal conditioning fluid 16 and/or gas during filling and/or draining of the silencer 15. The first flat entrance plane 30 is substantially parallel to the second flat entrance plane 32.

In the imaged embodiments, one first entrance 22 and one second entrance 24 is present. In alternative embodiments, the silencer 15 may comprise a plurality of first entrances 22 and/or a plurality of second entrances 24. Similarly, in alternative embodiments the first channel 23 may comprise multiple subchannels arranged in the first channel 23 and/or the second channel 25 may comprise multiple subchannels arranged in the second channel 25. In the imaged embodiments, the first channel 23 and the second channel 25 have a constant cross section. In alternative embodiments, a cross section of the first channel 23 may vary along a length of the first channel 23 and/or a cross section of the second channel 25 may vary along a length of the second channel 25.

The fluid volume of the silencer 15 is substantially cylindrically shaped. The housing wall 20 comprises a curved peripheral wall 36 and a first side wall 37 and a second side wall 38. The first entrance 22 comprises an opening in the peripheral wall 36 and the second entrance 24 also comprises an opening in the peripheral wall 36. The first entrance 22 has a substantially circular, substantially oval, substantially rectangular, or substantially triangular shape and the second entrance 24 also has a substantially circular, substantially oval, substantially rectangular, or substantially triangular shape.

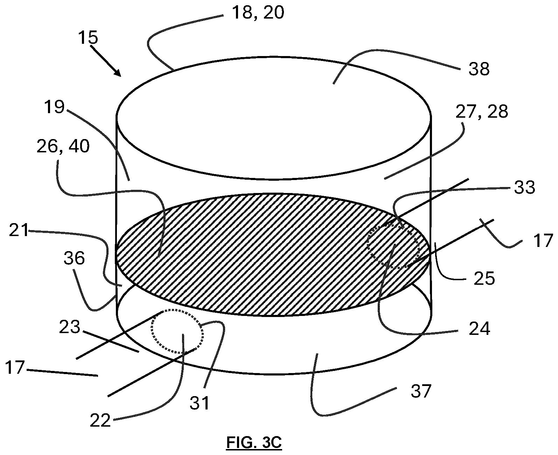

The first side wall 37 is preferably substantially parallel to the second side wall 38. The peripheral wall 36 is substantially cylindrically shaped and has a substantially constant radius. Therefore the peripheral wall 36 is substantially circularly shaped in figures 3A, 3C, 4, and 5. The first side wall 37 and/or the second side wall 38 are substantially flat and are substantially circularly shaped. Figure 3C shows that the silencer 15 comprises a compliant member 26 arranged in the inner cavity 19. The compliant member 26 divides the inner cavity 19 into the thermal conditioning fluid cavity 21 and a gas cavity 27. The gas cavity 27 forms a substantially closed space 28 within the inner cavity 19. The thermal conditioning fluid cavity 21 is configured to hold the thermal conditioning fluid 16 and wherein the gas cavity 27 is configured to hold a gas. The compliant member 26 and the gas cavity 27 aid in suppressing vibrations of the thermal conditioning fluid 16.

The compliant member 26 comprises a substantially planar member 40 which is arranged substantially parallel to the first side wall 37 or to the second side wall 38.

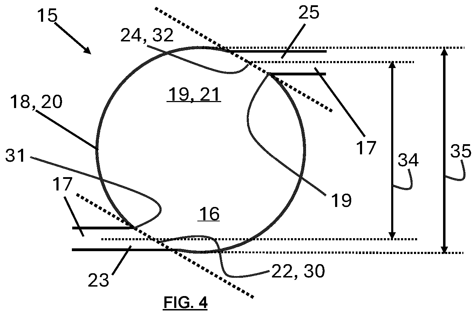

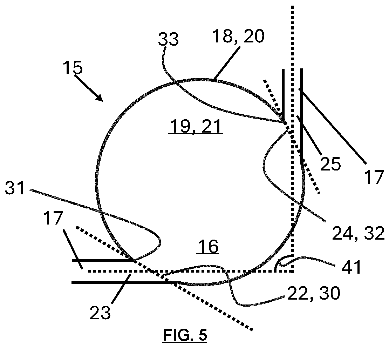

In the embodiments of figures 4 and 5, the first entrance 22 is arranged lower than the second entrance 24. This further tends to reduce the occurrence of pockets of thermal conditioning fluid 16 and/or gas during filling and/or draining of the silencer 15. A height difference 34 between the first entrance 22 and the second entrance 24 is at least 80% of a thermal conditioning fluid cavity height 35, preferably at least 90% of the thermal conditioning fluid cavity height 35, more preferably substantially equal to the thermal conditioning fluid cavity height 35. The first entrance 22 is arranged at substantially a same height as a lowest part of the thermal conditioning fluid cavity 21. This way, most or substantially all of the thermal conditioning fluid 16 can be drained from the thermal conditioning fluid cavity 21 under the influence of gravity alone.

In the embodiment of figure 4, the first channel 23 and the second channel 25 are substantially parallel to each other. In the embodiment of figure 5, the first channel 23 and the second channel 25 are arranged at an angle 41 with respect to each other. In this particular embodiment, the first channel 23 and the second channel 25 are preferably substantially perpendicular to each other. The embodiment of figure 4 may be referred to as a Z shaped arrangement, as the first channel 23 and the second channel 25 form a Z shape. The embodiment of figure 5 may be referred to as an L shaped arrangement, as the as the first channel 23 and the second channel 25 form an L shape.

Above, a silencer 15 is described. The silencer 15 may be part of a thermal conditioning system 47 configured to thermally condition an object. Such a thermal conditioning system 47 comprises a thermal conditioning fluid duct 17 configured to be connected to the object. Said thermal conditioning fluid duct 17 is configured to provide a flow of the thermal conditioning fluid 16 to the object. The thermal conditioning system 47 provides a flow of a thermal conditioning fluid 16 via the thermal conditioning fluid duct 17 to the object, and the silencer 15 silences disturbances in a disturbance frequency band in the thermal conditioning fluid 16.

A lithographic apparatus LA is an example of an apparatus that may comprise a silencer 15 and/or thermal conditioning system 47 as described above. In that case, the object may be one of a projection system PS mirror 13, 14, a substrate table WT, a support structure MT configured to support a patterning device MA, a force frame and a sensor frame of the lithographic apparatus LA. In such a lithographic apparatus LA, preferably one of the first channel 23 and the second channel 25 is arranged substantially horizontally, wherein preferably the first channel 23 is arranged substantially horizontally. This may be beneficial for packaging reasons, as space is limited in and around a lithographic apparatus LA.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A silencer configured to silence an acoustic wave in a thermal conditioning fluid in a thermal conditioning fluid duct, the silencer comprising:
- a silencer housing comprising an inner cavity, wherein the silencer housing comprises a housing wall defining the inner cavity, wherein a thermal conditioning fluid cavity is arranged inside the inner cavity,
- a first entrance arranged in the housing wall, the first entrance comprising an opening in the housing wall,
- a first channel connected to the first entrance and configured to be connected to the thermal conditioning fluid duct wherein the first channel is configured to supply thermal conditioning fluid from the thermal conditioning fluid duct via the first entrance to the thermal conditioning fluid cavity and/or to discharge thermal conditioning fluid from the thermal conditioning fluid cavity via the first entrance to the thermal conditioning fluid duct,
- a second entrance arranged in the housing wall, the second entrance comprising an opening in the housing wall,
- a second channel connected to the second entrance and configured to be connected to the thermal conditioning fluid duct wherein the second channel is configured to supply thermal conditioning fluid from the thermal conditioning fluid duct via the second entrance to the thermal conditioning fluid cavity and/or to discharge thermal conditioning fluid from the thermal conditioning fluid cavity via the second entrance to the thermal conditioning fluid duct,
wherein the first channel and the second channel are arranged fully outside the housing wall.

2. Silencer according to claim 1, the silencer comprising a compliant member arranged in the inner cavity, wherein the compliant member divides the inner cavity into the thermal conditioning fluid cavity and a gas cavity, wherein the gas cavity forms a substantially closed space within the inner cavity, wherein the thermal conditioning fluid cavity is configured to hold the thermal conditioning fluid and wherein the gas cavity is configured to hold a gas.

3. Silencer according to claim 1 or 2, wherein the first channel and the second channel do not protrude into the thermal conditioning fluid cavity.

4. Silencer according to any of claims 1 - 3, wherein the first entrance comprises a first flat entrance plane, wherein a first entrance rim surrounds the first entrance and lies in the first flat entrance plane, wherein the second entrance comprises a second flat entrance plane, wherein a second entrance rim surrounds the second entrance and lies in the second flat entrance plane, wherein the thermal conditioning fluid cavity is arranged substantially entirely between the first flat entrance plane and the second flat entrance plane.

5. Silencer according to claim 4, wherein the first flat entrance plane is substantially parallel to the second flat entrance plane.

6. Silencer according to any of claims 1 - 5, wherein the first entrance is arranged lower than the second entrance, wherein a height difference between the first entrance and the second entrance is at least 80% of a thermal conditioning fluid cavity height, preferably at least 90% of the thermal conditioning fluid cavity height, more preferably substantially equal to the thermal conditioning fluid cavity height.

7. Silencer according to any of claims 1 - 6, wherein the first entrance is arranged at substantially a same height as a lowest part of the thermal conditioning fluid cavity.

8. Silencer according to any of claims 1 - 7, wherein the fluid volume is substantially cylindrically shaped, wherein the housing wall comprises a curved peripheral wall and a first side wall and a second side wall, wherein the first side wall is preferably substantially parallel to the second side wall.

9. Silencer according to claim 8, wherein the peripheral wall is substantially cylindrically shaped with a substantially constant radius.

10. Silencer according to claim 8 or 9, wherein the first side wall and/or the second side wall are substantially flat.

11. Silencer according to any of claims 8 - 10, wherein the first side wall and/or the second side wall are substantially circularly shaped.

12. Silencer according to any of claims 8 - 11, wherein the first entrance comprises an opening in the peripheral wall and/or wherein the second entrance comprises an opening in the peripheral wall.

13. Silencer according to any of claims 8 - 12, the silencer furthermore comprising the features of claim 2, wherein the compliant member comprises a substantially planar member arranged substantially parallel to the first side wall.

14. Silencer according to any of claims 1 - 13, wherein the first channel and the second channel are substantially parallel to each other.

15. Silencer according to any of claims 1 - 13, wherein the first channel and the second channel are arranged at an angle with respect to each other, wherein the first channel and the second channel are preferably substantially perpendicular to each other.

16. Silencer according to any of claims 1 - 15, comprising a plurality of first entrances and/or a plurality of second entrances.

17. Silencer according to any of claims 1 - 16, wherein a cross section of the first channel varies along a length of the first channel and/or wherein a cross section of the second channel varies along a length of the second channel.

18. Silencer according to any of claims 1 - 17, wherein the first channel comprises multiple subchannels arranged in the first channel and/or wherein the second channel comprises multiple subchannels arranged in the second channel.

19. Silencer according to any of claims 1 - 18, wherein the first entrance has a substantially circular, substantially oval, substantially rectangular, or substantially triangular shape and/or wherein the second entrance has a substantially circular, substantially oval, substantially rectangular, or substantially triangular shape.

20. A thermal conditioning system configured to thermally condition an object, wherein the thermal conditioning system comprises a thermal conditioning fluid duct configured to be connected to the object and configured to provide a flow of the thermal conditioning fluid to the object, and at least one silencer according to any of claims 1 - 19.

21. A lithographic apparatus comprising an object and a thermal conditioning system according to claim 20 to thermally condition the object.

22. The lithographic apparatus according to claim 21, wherein the object is one of a projection system mirror, a substrate table, a support structure configured to support a patterning device, a force frame and a sensor frame of the lithographic apparatus.

23. Lithographic apparatus according to claim 21 or 22, wherein one of the first channel and the second channel is arranged substantially horizontally, wherein preferably the first channel is arranged substantially horizontally.

24. A method of thermally conditioning an object of a lithographic apparatus, comprising providing a flow of a thermal conditioning fluid via a thermal conditioning fluid duct to the object, the method comprising silencing disturbances in a disturbance frequency band in the thermal conditioning fluid by at least one silencer according to any of according to any of claims 1 - 19.

25. A method of removing liquid from a silencer according to any of claims 1 - 19, the method comprising draining the liquid out of the thermal conditioning fluid cavity via the first entrance and simultaneously supplying a different fluid to the thermal conditioning fluid cavity via the second entrance, the method preferably comprising removing substantially all liquid from the silencer.

26. A method of filling a silencer according to any of claims 1 - 19 with a liquid, the method comprising supplying the liquid to the thermal conditioning fluid cavity via the first entrance and optionally simultaneously removing a different fluid from the thermal conditioning fluid cavity via the second entrance, the method preferably comprising substantially fully filling the thermal conditioning fluid cavity.
